Europäisches Patentamt

European Patent Office

Office européen des brevets

(19)

(11) EP 1 318 409 A1

(12) **EUROPEAN PATENT APPLICATION**

(43) Date of publication:
**11.06.2003 Bulletin 2003/24**

(51) Int Cl.7: **G01R 1/073**

(21) Application number: **02005932.5**

(22) Date of filing: **15.03.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **06.12.2001 IT MI012574**

(71) Applicant: **Technoprobe S.r.l**
**23870 Cernusco Lombardone (LC) (IT)**

(72) Inventors:
• **Felici, Stefano**
**23899 Robbiate (Lecco) (IT)**
• **Crippa, Giuseppe**
**23807 Merate (Lecco) (IT)**

(74) Representative: **Botti, Mario**
**Botti & Ferrari S.r.l.,**
**Via Locatelli, 5**
**20124 Milano (IT)**

(54) **"Contact probe for a testing head."**

(57) A contact probe for a testing head is described, the probe having at least a pointed rod-shaped body (4) having a crook-shaped section (6) capable to contact mechanically and electrically at least one contact pad (7) of an electronic device (10) to be tested and defined form an elbow point (G) on the rod-shaped body (4).

Advantageously according to the invention, the rod-shaped body (4) comprises at least one additional elbow point (Ga) spaced form the elbow point (G).

FIG. 7A

**Description**

Field of Application

The present invention relates to a contact probe for a testing head.

More specifically, the invention relates to a contact probe for a testing head comprising at least a pointed rod-shaped body having a crook-shaped section suitable to mechanically and electrically contact at least one contact pad of an electronic device to be tested and defined from an elbow point on said at least one rod-shaped body.

The invention relates, particularly but not exclusively, to a probe for a testing head suitable for testing semiconductor integrated devices, the following description being given with reference to this application field for convenience of illustration only.

Prior Art

As it is well known, a testing head is basically a device suitable to electrically interconnect a plurality of contact pads of a microstructure and the corresponding channels of a testing machine that is to perform the tests.

Integrated circuits are factory tested in order to spot and reject any circuits which are already defective during the production phase. The testing heads are normally employed to electrically test the integrated circuits "on wafer", prior to cutting and mounting them in a chip package.

A large use is made of the so-called cantilever testing heads, i.e. testing heads comprising a plurality of probes projecting in a cantilever way from a suitable holder.

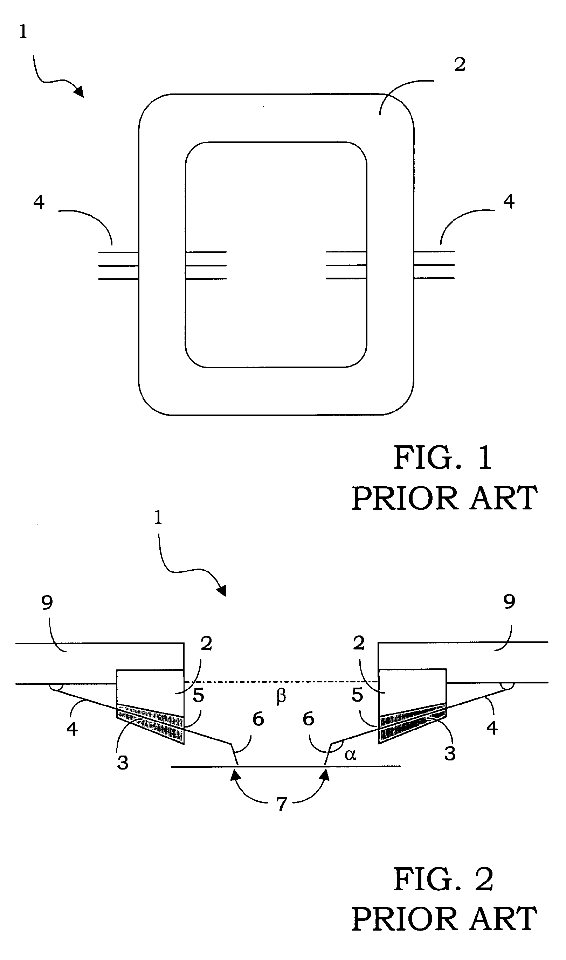

More particularly, as schematically shown in Figures 1 and 2, a testing head 1 having cantilever probes usually comprises a backing ring 2, made of aluminium, ceramics or other suitable materials, to which a resin holder 3 is attached, and that is suitable to hold a plurality of movable contact elements or contact probes 4, being normally wires made of special alloys having good electrical and mechanical properties, the probes being mounted to jut out of the resin holder 3 at plural points 5 and at a suitable angle from a plane β. Such emerging probes are commonly known as "cantilever probes".

In particular, each contact probe 4 has an end portion or contact tip 6, which is bent with a suitable angle γ from the probe axis so that a plurality of contact pads 7 of a device to be tested is contacted. The bent contact tips 6 are commonly referred to as the "crooks".

The good connection of the contact probes 4 of the testing head 1 to the contact pads 7 of a device to be tested is ensured by the testing head 1 exerting a pressure on the device, whereby the contact probes 4 are vertically flexed in the opposite direction from the device movement towards the testing head 1.

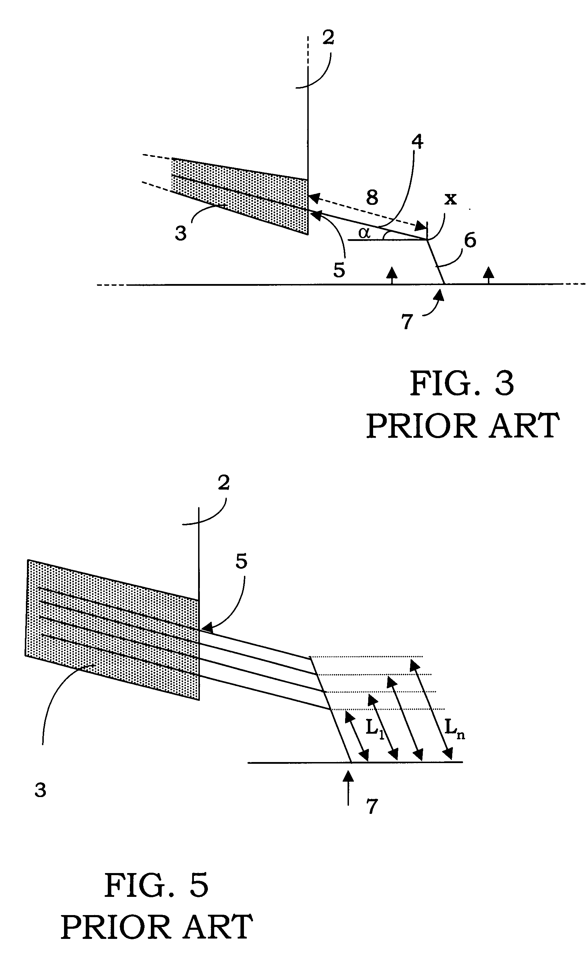

As schematically shown in Figure 3 for a single contact probe 4, as the device to be tested vertically moves against the contact crook 6, the contact probe 4 flexes, and its elbow point X, situated at the transition from the contact crook 6 to a probe section 8 emerging from the resin holder 3, describes a circular arc.

Thus, the jutting probe section 8 forms a working arm of the contact probe 4 adapted to flex vertically, and is commonly referred to as "free length".

The crooked shape of the contact probes 4 is designed to allow the contact crooks 6 of the probes 4 to skid, upon coming in touch with the contact pads 7 of the device to be tested and during the pad overtravel beyond a pre-set point of contact, across the contact pads 7 along a direction dictated by the arrangement geometry.

It should be noted that the force exerted on the contact pads 7 by each contact probe 4 depends on many factors, among which are especially the type of material forming the contact probe 4, the probe shape, the angle $\alpha$ made by the probe contact crook 6, the length of the probe jutting section or free length 8, and the amount of overtravel of the pads to be measured. These factors also determine the extent of the contact crooks 6 skidding on the contact pads 7, this being commonly known as the "scrub".

Also known in this field is to use backing rings 2, generally made of aluminium, ceramics or other suitable materials, having different shapes depending on the set of contact pads 7 to be tested, so that the free lengths of the contact probes 4, and hence the forces exerted by the latter to the contact pads 7, can be equalised in the interest of even wear and performance of the testing head 1.

The portions of the contact probes 4 outside the backing ring 2 are usually soldered on a PC board 9, as shown in Figure 2, to establish an electrical connection between the testing head 1 having cantilever probes and the testing machine.

The known testing heads have inherent limitations in the distance between two adjacent probes, and therefore in the distance between the centre of two contact pads of the integrated electronic device to be tested, this distance being known in this field with the English term "pitch". Particularly, the minimum "pitch" value depends on the geometric layout and the size of the probes. To avoid the contact between adjacent probes, the testing head 1 must comply with the following relation:

$$X > fc + S$$

where

    X is the pitch value of the device to be tested, i.e. the distance between the centre of two adjacent contact pads;

fc is the diameter of the contact probes 4; and

S is the safety distance between adjacent contact probes 4.

The condition S=0, i.e. the safety distance being equal to 0, corresponds to the collision of the probes.

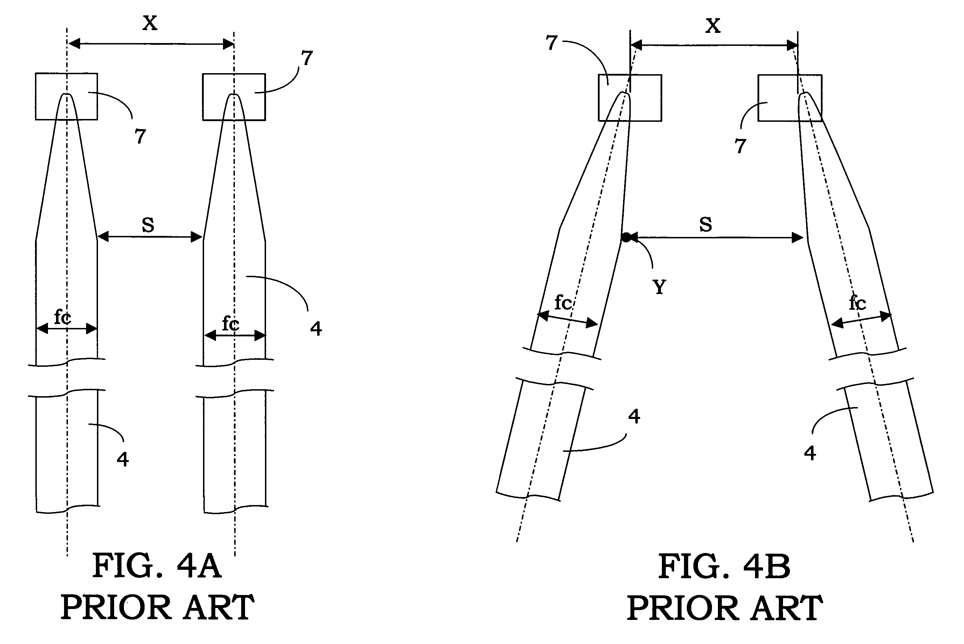

The collision of the probes occurs along the body of the contact probes 4 when they are positioned with parallel axes, as schematically shown in figure 4A, or in correspondence with a starting point Y of the contact probes 4 taper when they are positioned with convergent axes, as schematically shown in figure 4B.

To increase the probe number, with the same pitch value, present technologies are known to reduce the size of the contact probes 4, and particularly the diameter fc thereof, with a subsequent weakening thereof. Such a solution is thus applicable in a limited number of cases.

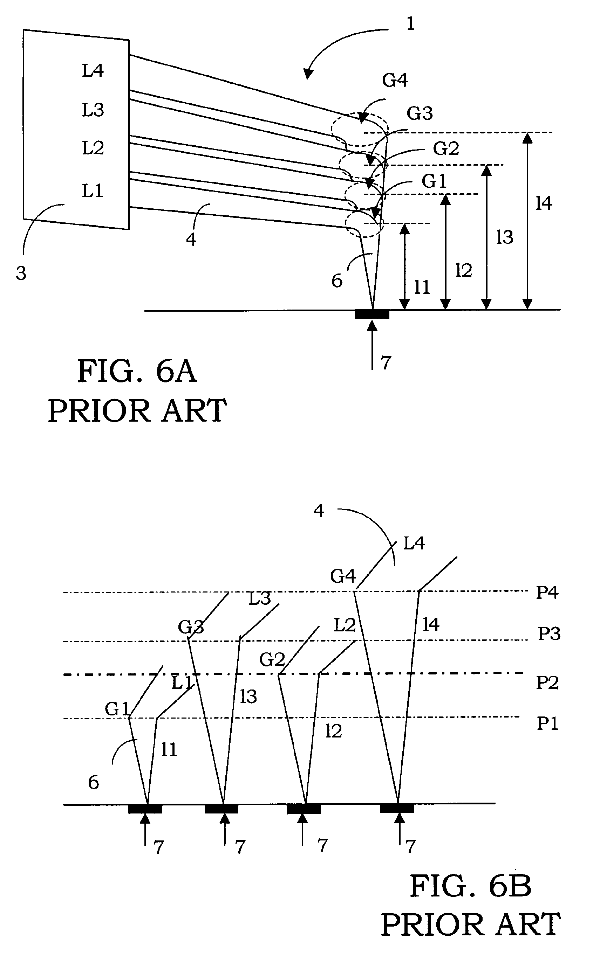

It should be noted that, with a dense distribution of the contact pads 7, the contact probes 4 must be arranged in plural rows, and the lengths L1,..., Ln of the crooks 6 vary accordingly, as schematically shown in Figure 5.

The N number of levels required to arrange a plurality of contact probes 4 having diameter fc on contact pads 7 having a distance or pitch equal to X, keeping them at a safety distance S, is calculated through the following empirical formula:

$$N = (fc+S)/X$$

In the case of a testing head with cantilever contact probes 4 arranged in a plurality of levels, it appears that the problem of probe collision is tridimensional. Particularly, the highest contact risk points are the elbow points of probes having a level corresponding to low tapered areas of the crooks 6 of adjacent contact probes 4.

For convenience of illustration, reference is now made to the embodiment of a testing head 1 of the prior art comprising contact probes 4 arranged on four levels, as schematically shown in figures 6A and 6B.

Particularly, these figures schematically show respective side and front views of a plurality of contact pads 4 arranged on N=4 levels, indicated with L1...L4. The contact probes 4 have thus contact crooks 6 with four different lengths, indicated with l1...l4, attached to the body of the probes 4 in respective elbow points G1... G4.

Known is to alternate the contact probes 4 so that the crooks 6 of adjacent probes 4 are not in progression to each other. In the front view of Figure 6B it can be thus noted that the sequence of the crooks 6 is l1 followed by l3 followed by l2 followed by l4.

The collision risk between the contact probes 4 can be checked considering the distances between the respective crooks 6 on the planes P1...P4 in correspondence with the elbow points G1...G4.

It appears immediately that the highest collision risk of the configuration shown in figures 6A and 6B is located in correspondence of the elbow point G2 on the plane P2, i.e. of the contact probe of level L2, being the sections of the crooks of the adjacent probes of level L3 and L4 low tapered in correspondence of the plane P2 of the elbow point G2.

In other terms, the probe minimum distance points are between the probe of level L2 and the probe of level L3, as well as between the probe of level L2 and the probe of level L4.

Similarly, it can be verified that the collision risk points, i.e. the minimum distance points, for an arrangement on N=3 levels, are in correspondence with the elbow point G2 of the probe of level L3, i.e. between the probe of level L2 and the probe of level L3, while for an arrangement on N=5 levels they are in correspondence with the elbow point G3 of the probe of level L3, i.e. between the probe of level L3 and the probe of level L4 and between the probe of level L3 and the probe of level L5.

It is therefore convenient, if possible, to arrange the contact probes 4 on the lowest possible number of levels.

In substance, the selection of the arrangement configuration of the contact probes 4 on more levels depend on many factors among which the most relevant are the following:

- space available for the whole contact probes 4;

- diameter fc of each contact probe 4;

- shape of the contact crook 6; and

- pitch of the device to be tested.

By setting the pitch value of the device to be tested, it is possible to increase the number of the probes which can be housed in each single level, reducing the diameter thereof.

It is worth noting that contact probes 4 with small diameter have reduced electrical and mechanical performances connected to the increase in the contact resistance between the crooks and the pads of the device to be tested because of the lower pressure exerted by the tips of the contact probes 4 on the respective contact pads 7.

In addition, during the measuring operations on the device to be tested, this device is shifted towards the testing head 1 so that the crook tips of the contact probes abut the corresponding contact pads; once in contact, the movement of the device towards the testing head 1 continues at an extent equal to the so-called pre-

set overtravel in order to ensure a good pressure of the probe tips and, therefore, a good contact resistance Rc between contact probes 4 and contact pads 7 of the device to be tested.

The movement of the tips on the pads causes the etching of the latter and the production of etching marks usually referred to as "scrub marks", whose length essentially depends on the following parameters:

   a) length In of the crooks 6 of the contact probes 4;

   b) overtravel value;

   c) free-length value of the contact probes 4 and slant angle $\alpha$ thereof.

A small value of scrub marks means that the testing is not too invasive and it reduces the damages on the contact pads 7 caused by the tips of the contact probes 4, allowing therefore a good quality bonding which is subsequently implemented on these pads to be obtained.

It is therefore worth producing contact probes 4 causing the smallest possible scrub marks.

It can be easily noted that the scrub mark length is highly dependent on the crook length. When the N number of levels increases, involving an increase in the crook length, also the length of the scrub marks associated thereto increases.

Particularly, in a testing head having contact probes 4 on four levels, the probe of level I1, whose crook has a length l1, produces a shorter scrub mark than the probe of level L2, whose crook has a length l2, which scrub mark is in turn shorter than the scrub mark produced by the probe of level L3, whose crook has a length l3.

The probe of the highest level, L4, whose crook has the greatest length, 14, will produce therefore the longest scrub mark, causing, in correspondence therewith, the greatest damages on the contact pads 7.

In addition, it can be easily noted that an increase in the overdrive value results in an improved contact resistance Rc of the probe tips on the contact pads 7 since the probe pressure on these pads increases.

On the contrary, an increase in the overdrive value results in an increased overall scrubbing effect of the contact tips, with the further risk that the tips of the contact probes 4 "skid" outside the area defined by the contact pads 7.

It is possible to try and reduce this skidding risk of the contact probes 4 tips outside the device contact pads 7 by using pads which are elongated in the scrub mark direction, for example by using rectangular contact pads 7, with the longest side arranged along the tip skidding direction, to the detriment of the overall pad area occupation on the device to be tested.

It is finally possible to verify that the scrub mark lengths increase when the elbow angle of the crooks 6 of the contact probe 4 increases and when the free length of the contact probes decreases.

At present, the market trend leads to the design of devices which are more and more dense. It is therefore essential to arrange the probes on more levels, even over the four conventional levels, and to use contact probes which have very small diameter, even less than 100u, and thus inherently not sufficient to ensure good electrical and mechanical performances.

Unfortunately, the need to arrange the probes on several levels contrasts with the need to limit or even reduce the scrub mark length, and consequently the contact pad 7 damage and the skidding risk, mainly because the contact pads 7 size tends to be constantly reduced.

By using contact pads 7 having an elongated shape, for example rectangular, it is possible to accept higher scrub mark values and therefore a higher pressure, improving the contact between the contact probes 4 and the contact pads 7, and avoiding in the meantime the tip skidding outside the contact area of the pads 7, particularly for the tips of the highest level probes, which cause the longest scrub marks.

This solution can be considered only partial and not very suitable due to the area waste on the device to be tested.

In addition, the increase in the number of levels leads to an increase in the collision risk between the highest levels since also the minimum distance therewith is proportionally reduced.

As it appears from the above, there are opposite needs requiring very precarious compromise solutions which endanger, even seriously, the good operation of the testing heads 1 according to the prior art.

The technical problem underlying the present invention is to provide a testing head for microstructures having a configuration which is capable to reduce the pitch of the device to be tested, increase the safety area between the probes and reduce the tip scrub on the contact pads, always ensuring a suitable mechanical and electrical contact between the probes and the contact pads.

Summary of the Invention

The solutive idea underlying the present invention is to modify the contact probe configuration and reduce the length of the corresponding crooks, ensuring however the arrangement thereof on several levels.

Particularly, the solutive idea is to insert at least one additional elbow point between an emerging point of the probe from an holder and the elbow point defining the crook.

Based on this solutive idea, the technical problem is solved by a contact probe for a testing head comprising at least one pointed rod-shaped body having a crook-shaped section capable to mechanically and electrically contact at least one contact pad of an electronic device to be tested and defined form an elbow point on said at least one rod-shaped body, characterised in that said at least one rod-shaped body comprises at least one additional elbow point spaced from said elbow point.

The characteristics and advantages of the contact probe according to the invention will be apparent from the following description of embodiments thereof, given by way of non-limiting examples with reference to the accompanying drawings.

Brief Description of the Drawings

In the drawings:

- Figure 1 shows a top plan view of a testing head having cantilever probes, according to the prior art;

- Figure 2 shows a sectional view of the testing head having cantilever probes of Figure 1;

- Figure 3 shows a sectional view of a detail of the testing head having cantilever probes of Figure 1;

- Figures 4A and 4B show respective top plan views of further embodiments of a detail of the testing head having cantilever probes of figure 1;

- Figure 5 shows a sectional view of a detail of an embodiment of a testing head having cantilever probes according to the prior art;

- Figures 6A and 6B show respective schematic views of an embodiment of a testing head having cantilever probes according to the prior art;

- Figures 7A and 7B show respective schematic views of an embodiment of cantilever probes according to the invention;

- Figures 8A and 8B show respective schematic views of a further embodiment of cantilever probes according to the invention;

- Figures 9A to 9F schematically show further embodiments of the cantilever probes according to the invention; and

- Figures 10A and 10B schematically show the operation of the contact probes according to the invention and of contact probes according to the prior art when compared to each other.

Detailed Description

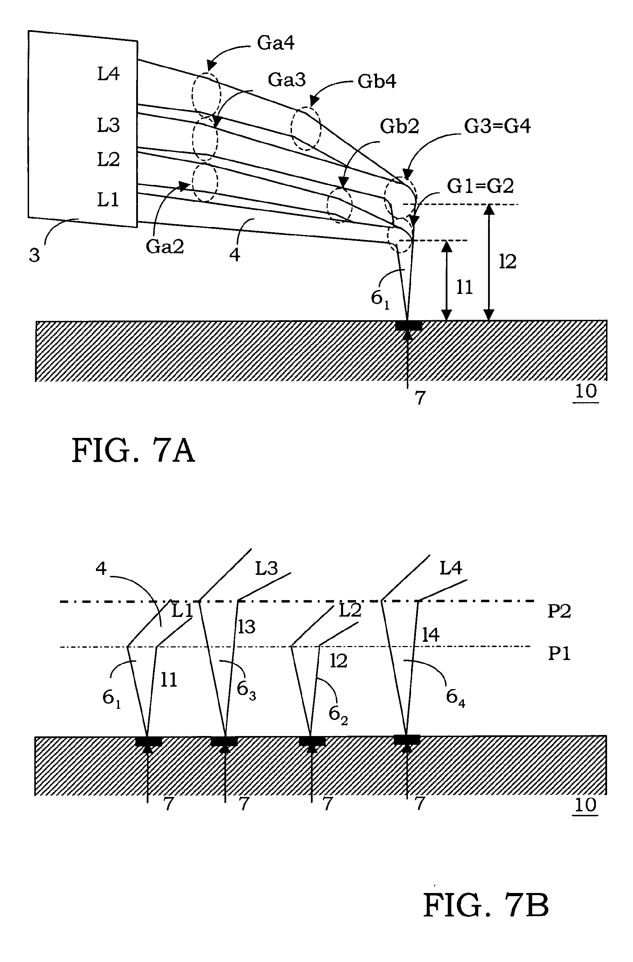

With reference in particular to Figures 7A and 7B, for convenience of illustration, shown is a testing head comprising only four contact probes, being clearly understood that the testing head according to the invention comprises any number of movable probes and that the invention is not limited to this embodiment, having instead a completely general character.

In addition, structurally and functionally identical elements with respect to the prior art have the same reference numbers, for convenience of illustration.

The testing head comprises therefore a resin holder 3 capable to hold a plurality of cantilever contact probes 4.

Particularly, the contact probes 4 comprise a pointed substantially rod-shaped body and have an end portion called crook 6, bent in correspondence with a so-called elbow point, in order to contact a plurality of contact pads 7 of the device 10 being tested, the bonding between the contact probes 4 and these contact pads 7 being ensured by the pressure of the testing head on the device 10. The contact probes 4 flex therefore vertically in the opposite direction from the device movement to the testing head.

The testing head according to the invention comprise a plurality of contact probes 4 arranged in a plurality of levels. Particularly, the testing head shown in figure 7A comprises at least four probes arranges, emerging from the holder 3, on four levels L1, ..., L4 and having four crooks $6_1$, ..., $6_4$ respectively.

Advantageously according to the invention, the contact probes 4 further have, besides the starting elbow point G1, ..., G4 of the crooks 6, an additional elbow point Ga2,..., Ga4 located in the probe section between the holder 3 and said crooks. This additional elbow point defines at least one probe section which is bent in the same direction as the crooks 6.

In this way, it is possible to reduce the lengths of the crooks 6, spacing thereby the collision risk points, as seen with reference to the prior art. In fact, the crook starting elbow points are nearer to the tips of the contact probes 4 and therefore more spaced to each other.

Generally, the elbow points can form live angle, curvilinear or circle arch junctions between the probe adjacent sections.

A further preferred embodiment of the invention, to avoid too acute elbow points, further provides additional elbow points Gb2, Gb4 capable to define a plurality of probe sections, advantageously bent in the same direction as the crooks 6 to further reduce the length.

In the example of figure 7A, the probe of level L2 has therefore a first additional elbow point Ga2 in correspondence of the holder 3, a second additional elbow point Gb2 before the starting elbow point G2 of the crook $6_2$. The length of the crook $6_2$ of this probe is equalised to a length l1 of the crook $6_1$ of the probe of level L1, as shown in figure 7B.

Similarly, the probe of level L3 has therefore a first additional elbow point Ga3 in correspondence of the holder 3, after the starting elbow point G3 of the crook $6_3$, in order to reduce the length of the crook $6_3$ at a

length l2 higher than the length l1 of the crook $6_1$ and $6_2$ of the probes of level L1 and L2, but lower than the length l3 of the crook of level L3 produced according to the prior art.

Finally, the probe of level L4 has a first additional elbow point Ga4 in correspondence with the holder 3 and a second additional elbow point Gb4 before the starting elbow point G4 of the crook $6_4$, in order to reduce the length of the crook $6_4$ at the length 12 of the crook $6_3$ of the probes of level L3.

The testing head shown in figure 7A has therefore crook starting elbow points only in correspondence with a first plane P1 and a second plane P2, with an increase of the distances between the probes and a subsequent reduction of collision risks.

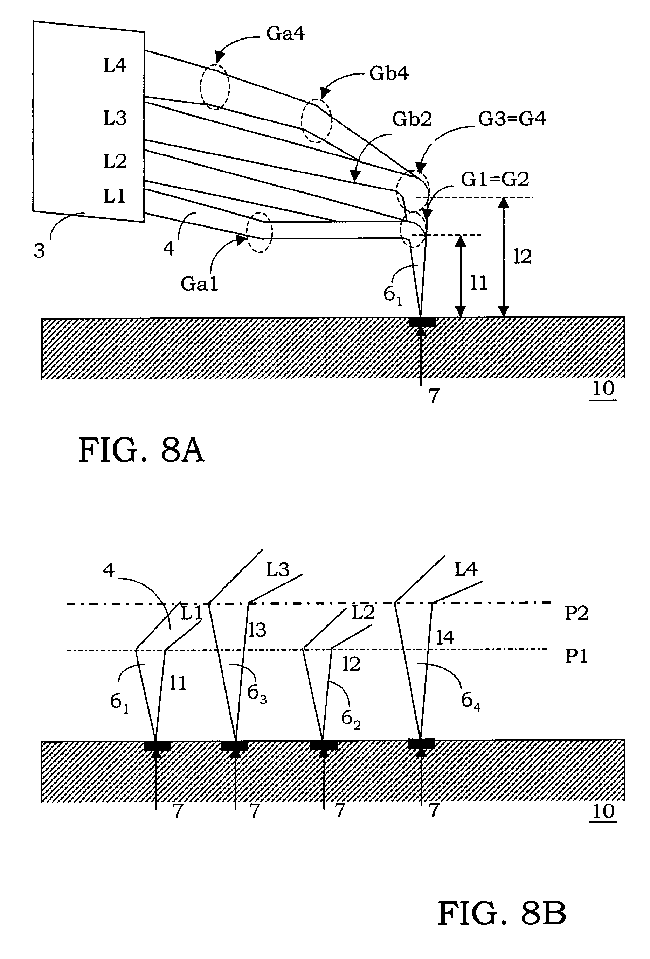

In a further embodiment schematically shown in figure 8A, the probe of level L1 has therefore an additional elbow point Ga1 defining a concave angle in the body of the probe 14. Particularly, the probe body descends at a high slope from the holder 3, and then it continues substantially parallel with the plane of the device to be tested up to the elbow point G1 located at level l1 of the crook 61. The length of the crook 62 of this probe is equalised to a length l1 of the crook 62 of the probe of level L2, as shown in figure 8B.

It is also possible to consider the case in which the probe body goes back to the elbow point G1 starting from the additional elbow point Ga1, in a more or less sloped way with respect to the plane of the device to be tested.

Similarly, the probe of level L4 has therefore an additional elbow point Ga4 in correspondence with the holder 3, after the starting elbow point G4 of the crook 64, in order to reduce the length of the crook $6_4$ at a length 12 higher than the length l1 of the crook $6_1$ and $6_2$ of the probes of level L1 and L2, but lower than the length 14 of the crook of level L4 produced according to the prior art and particularly equal to the length l3 of the crook of the probe of level L3.

The testing head shown in figure 8A has still crook starting elbow points only in correspondence with a first plane P1 and a second plane P2, with an increase in the distances between the probes and a subsequent reduction of collision risks.

More generally, the testing head according to the invention comprises multi-ply contact probes 4 comprising a plurality of sections separated by elbow points in order to obtain a desired reduction of the length of the crooks of the different probe levels and of the probe collision risk.

Taking to the limit the number of additional elbow points inserted, it is possible to produce substantially curvilinear probes.

A testing head according to the prior art schematically shown in Figure 6A and a testing head according to the invention schematically shown in figure 7A or 8A will now be compared. By considering the typical quantity values of the testing heads, the length of the known head crooks is between l1=200u and l4=500u with distances of 100u between the levels. In the case of the head according to the invention only the crooks of length l1=l2=200u and l3=l4=300u are available.

It appears therefore how, in the case of the testing heads according to the prior art, the length of the crooks 6 increases rapidly as levels increase, particularly, in the example shown, by a value equal to additional 300u for the three levels L2 L3 L4, while in the case of the technique according to the invention, the length of the crooks 6 increases only by additional 100u for the same levels L2 L3 L4.

Generally, it can be stated that, while in the traditional technology each level Ln corresponds to a length ln of the crook which is greater than the length ln-1 of the crook of the lower level probe, the testing head according to the invention comprises several subsequent levels, Ln-1 and Ln, with crooks having the same length ln-1 corresponding to the lowest level Ln-1.

Advantageously according to the invention, the probe sections can be straight, curvilinear or mixed, each section having a suitable length, and jointed to each other in the most advantageous way to obtain the desired length crooks.

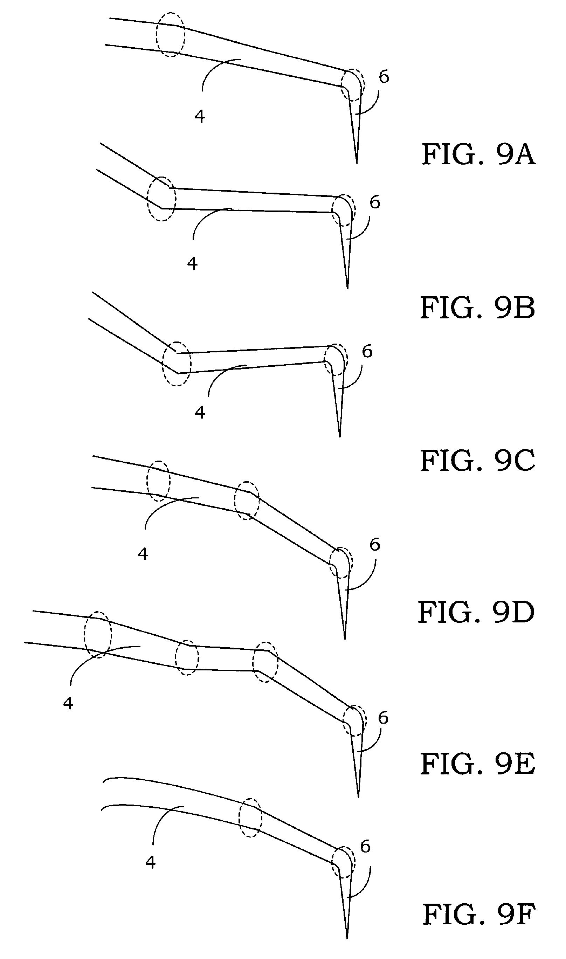

Some embodiments, given by way of non limiting example, of multiply contact probes according to the invention are shown in figures 9A and 9F.

These multiply probes can have one or more straight or curvilinear or mixed sections.

Advantageously according to the invention, the multiply contact probes 4 can be gathered together, reducing the length of the crooks and spacing from each other, by means of suitable bending, the collision risk points.

The testing head according to the invention, due to the reduction of the crook lengths, has the following additional advantages:

a) Possibility of using sturdier tips, i.e. tips with greater diameter, without risking the collision between adjacent probes.

In fact, with equal pitch and crook length ln, the safety area S between the probes in the elbow point thereof is much greater in the case of multiply probes according to the invention with respect to the probes according to the traditional one-ply technique. This implies that, once the minimum safety distance S set, it is possible to use sturdier probes ensuring a greater pressure of the crooks on the contact pads and, therefore, a greater contact resistance, more reliable electric measures and higher selection yields.

b) Reduction of the crook length and, thus, of the scrub marks.

It can be easily noted that, when the levels, and thus the crook lengths, increase, the scrub mark length also increases almost proportionally.

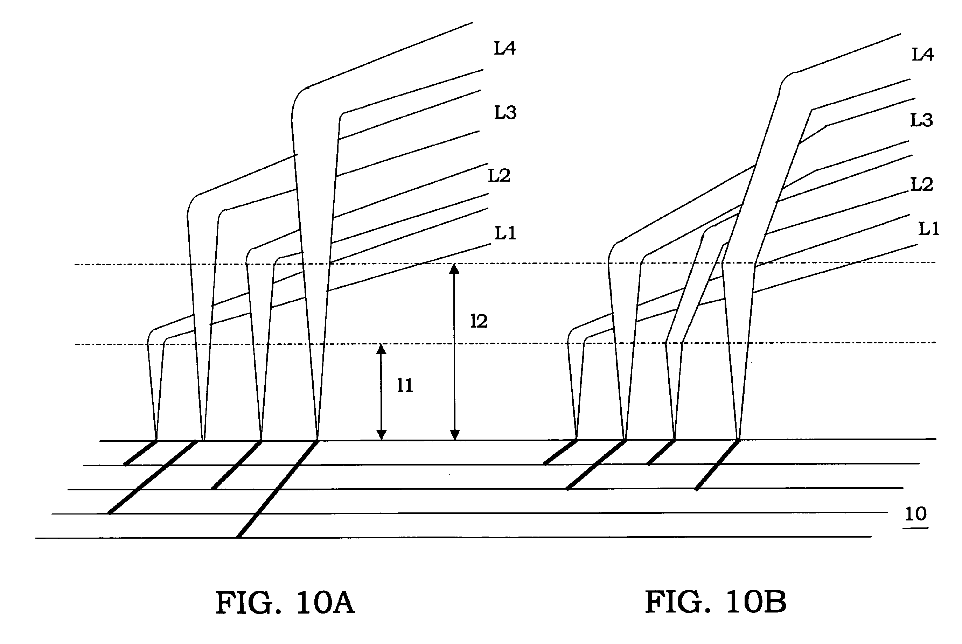

Figures 10A and 10B schematically show the scrub marks obtained with a testing head according to the traditional technology (figure 10A) and those obtained with a testing head according to the invention with the multiply technique (figure 10B).

Particularly, it appears that the crook length reduction obtained by using the multiply technique reduces in a substantially proportional way the scrub mark value.

c) Damage reduction of the contact pads of the device to be tested.

In fact, it appears that, by reducing the scrub mark length by means of the multiply technique according to the invention, the damaged area of the contact pads is reduced. A better quality of the following bonding operations to be implemented on the device contact pads is thereby allowed.

d) Possibility of testing devices having smaller pitch with respect to the traditional testing heads.

In fact, it appears that, with the same size of the probes used, the testing head according to the invention allows reduced pitch devices to be tested with high quality and reliability. The new technology requirements, asking for more and more reduced contact pads and pitch size, are therefore satisfied.

e) Possibility of reducing the contact pad size, and therefore, lower silicon consumption.

Due to the scrub mark reduction, it is possible to reduce the contact pad size, obtaining a considerable area gain; with the same silicon area it will be possible to produce a greater number of devices.

In conclusion, the testing head according to the invention allows:

- A reduction of the crook length of the contact probes;

- An increase in the probe diameter without risking a collision therebetween, improving therefore the contact resistance Rc;

- A reduction of the scrub mark length for the same overdrive;

- An increase in the contact pressure between probes and contact pads;

- A reduction of the usable pitch value;

- A reduction of the contact pad size to be used;

- An increase in the area between the probe and, therefore, easier manufacture and greater reliability of the whole testing head.

**Claims**

1. A contact probe for a testing head comprising at least one pointed rod-shaped body (4) having a crook-shaped section (6) capable to mechanically and electrically contact at least one contact pad (7) of an electronic device to be tested (10) and defined from an elbow point (G) on said at least rod-shaped body (4) **characterised in that** at least one rod-shaped body (4) comprises at least an additional elbow point (Ga) spaced from said elbow point (G).

2. A contact probe according to Claim 1, **characterised in that** said additional elbow point (Ga) defines with said elbow point (G) at least a probe section bent in the same direction as said crook-shaped section (6).

3. A contact probe according to Claim 1, **characterised in that** said additional elbow point (Ga) defines with said elbow point (G) at lease a probe section being substantially parallel to a plane of said electronic device (10) to be tested.

4. A contact probe according to Claim 1, **characterised in that** said additional elbow point (Ga) defines with said elbow point (G) at least a probe section bent in the opposite direction to said crook-shaped section (6).

5. A contact probe according to Claims 2, 3 or 4, **characterised in that** said at least probe section is straight.

6. A contact probe according to Claims 2, 3 or 4, **characterised in that** said at least probe section is curvilinear.

7. A contact probe according to Claim 1, **characterised in that** said at least one rod-shaped body (4) comprises a plurality of additional elbow points (Ga, Gb,...) capable to define a plurality of probe sections.

8. A contact probe according to Claim 7, **characterised in that** said plurality of probe sections comprises at least a straight section.

9. A contact probe according to Claim 7, **characterised in that** said plurality of probe sections comprises at least a curvilinear section.

10. A contact probe according to Claim 7, **characterised in that** said plurality of probe sections comprises at least a straight and a curvilinear sections.

11. A contact probe according to any of Claims 1 to 10, **characterised in that** said elbow points form live angle junctions between adjacent sections of said probe (4).

12. A contact probe according to any of Claims 1 to 10, **characterised in that** said elbow points form curvilinear junctions between adjacent sections of said probe (4).

13. A contact probe according to Claim 12, **characterised in that** said curvilinear junctions comprise circle arches.

14. Contact probe according to Claim 7, **characterised in that** said plurality of additional elbow points on said rod-shaped body (4) is so dense that said rod-shaped body (4) of said probe is substantially curvilinear.

15. Testing head with cantilever probes comprising a plurality of contact probes (4) having a plurality of crook-shaped sections (6) capable to ensure the mechanical and electrical contact with a plurality of contact pads (7) of at least one electronic device (10) to be tested, **characterised in that** it comprises at least one contact pad (4) according to any of the claim 1 to 14.

FIG. 1
PRIOR ART

FIG. 2
PRIOR ART

FIG. 3
PRIOR ART

FIG. 5
PRIOR ART

FIG. 4B
PRIOR ART

FIG. 4A
PRIOR ART

FIG. 6A
PRIOR ART

FIG. 6B
PRIOR ART

FIG. 7A

FIG. 7B

FIG. 8A

FIG. 8B

FIG. 9A

FIG. 9B

FIG. 9C

FIG. 9D

FIG. 9E

FIG. 9F

FIG. 10A

FIG. 10B

**European Patent Office**

**EUROPEAN SEARCH REPORT**

Application Number

EP 02 00 5932

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 599 559 A (EVANS ARTHUR) 8 July 1986 (1986-07-08) * abstract * | 1-3,5,6, 11-13,15 | G01R1/073 |
| A | * column 5, line 16 - line 44 * * figure 3 * | 7 | |
| X | US 6 298 312 B1 (CHEN SHU MIN) 2 October 2001 (2001-10-02) * column 4, line 23 - line 47 * * figure 4 * | 1 | |
| X | PATENT ABSTRACTS OF JAPAN vol. 2000, no. 19, 5 June 2001 (2001-06-05) & JP 2001 041978 A (JAPAN ELECTRONIC MATERIALS CORP), 16 February 2001 (2001-02-16) * abstract * | 1,4 | |
| X | WO 98 30914 A (NGUYEN LOI ;NGUYEN PETER HOANG (US)) 16 July 1998 (1998-07-16) * figures 2-4 * | 1,4 | TECHNICAL FIELDS SEARCHED (Int.Cl.7) G01R |
| A | PATENT ABSTRACTS OF JAPAN vol. 018, no. 596 (P-1825), 14 November 1994 (1994-11-14) & JP 06 222079 A (TOKYO KASOODE KENKYUSHO:KK), 12 August 1994 (1994-08-12) * abstract * | 1 | |

The present search report has been drawn up for all claims

| Place of search | Date of completion of the search | Examiner |
|---|---|---|
| THE HAGUE | 30 May 2002 | Lopez-Carrasco, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                EP 02 00 5932

This annex lists the patent family members relating to the patent documents cited in the above–mentioned European search report.
The members are as contained in the European Patent Office EDP file on
The European Patent Office is in no way liable for these particulars which are merely given for the purpose of information.

30-05-2002

| Patent document cited in search report | | Publication date | Patent family member(s) | | Publication date |
|---|---|---|---|---|---|
| US 4599559 | A | 08-07-1986 | DE<br>EP<br>JP<br>US | 3465147 D1<br>0127295 A1<br>59204246 A<br>4719417 A | 03-09-1987<br>05-12-1984<br>19-11-1984<br>12-01-1988 |
| US 6298312 | B1 | 02-10-2001 | NONE | | |
| JP 2001041978 | A | 16-02-2001 | NONE | | |
| WO 9830914 | A | 16-07-1998 | AU<br>WO | 5912898 A<br>9830914 A1 | 03-08-1998<br>16-07-1998 |
| JP 06222079 8 | A | 28-09-1987 | JP<br>JP | 1631855 C<br>2053677 B | 26-12-1991<br>19-11-1990 |

EPO FORM P0459

For more details about this annex : see Official Journal of the European Patent Office, No. 12/82